(19)

Europäisches
Patentamt
European
Patent Office
Office européen
des brevets

(11) **EP 2 015 204 A1**

(12) **EUROPEAN PATENT APPLICATION**

(43) Date of publication:
**14.01.2009 Bulletin 2009/03**

(51) Int Cl.:
***G06F 17/50*** (2006.01)

(21) Application number: **07111896.2**

(22) Date of filing: **06.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Seiko Epson Corporation**
**Shinjuku-ku,**
**Tokyo 163-0811 (JP)**

(72) Inventors:
• **Siero-Cordoba, Javier**
 **Universitat de Barcelona**
 **Marti Franquès 1**
 **08028 Barcelona (ES)**

• **Lopez Villegas, José Maria**
 **Universitat de Barcelona**
 **Marti Franquès 1**
 **08028 Barcelona (ES)**
• **Tanaka, Kazuaki**
 **Epson Europe Elect. GmbH**
 **08190 Sant Cugat del Vallés, Barcelona (ES)**

(74) Representative: **Carpintero Lopez, Francisco et al**
 **Herrero & Asociados, S.L.**
 **Alcalá 35**
 **28014 Madrid (ES)**

(54) **Method for generating an inductor library**

(57) The invention refers to a method for generating an inductor library which comprises iterating a method for generating an optimized inductor, which generation includes obtaining a minimum size boundary for the outer dimension $D$ of the inductor, and for a given inductance value $L_{eq}$ :
- fix a starting set of parameters $\{N, s_{min}, w_{min}, d_{min}\}$ of the inductor with said minimum size boundary,
- modify the constant turn-width $w_{min}$ to obtain the optimized turn-width $w_{opt}$ which enhances the Q factor of the inductor;
- modify the inner dimension $d_{min}$ to adjust the inductance value $d(L_{eq})$;
- modify the turn-width in each turn to take into account the magnetic flux, making the (i+1)-th turn wider than the i-th turn and obtaining a set of optimized turn-widths $\{w_1, w_2, ..., w_N\}$;
- calculate the new equivalent inductance value $L_{eq}'$, whereby the optimized inductor is defined by the following parameters $\{L_{eq}', N, s_{min}, w_1, w_2, ..., w_N, d(L_{eq})\}$.

FIG. 1

EP 2 015 204 A1

**Description**

Field of the invention

The present invention lies in the field of the design of RF integrated circuits, and more specifically in the design and optimization of spiral inductors fabricated on semiconductor substrates.

The present invention can be applied in a wide diversity of fields, such as semiconductor radio-frequency integrated circuit for wireless or wire-line communication, high-speed optical communication.

Background of the invention

One of the key factors in the design for low cost, low supply voltage, low power dissipation and low noise RF integrated circuits (RF-ICs) is the requirement of high-Q RF inductors, Despite the great incentive to optimize spiral inductors fabricated on Si substrates, the inductance behaviour and the Quality factor (Q factor) prediction for integrated circuits is still a difficult task Indeed, parasitic effects, such as coupling capacitance and substrate losses are particularly important using silicon substrates. Since the introduction of Si spiral inductors, many authors have disserted thoroughly on the improvement and analysis of the performance of these structures.

Recently, the tendency in the design of RF-ICs is to generate an inductor library on a silicon-based technology. Despite the fact that many useful works have focuses on automating the inductor layout generation, little has been written about integrated inductor library development on Si substrates,

A common used solution consists in characterizing an inductor library at an early stage of technology development. In many cases, the manufacturing foundry provides a general standard library or PDK (Process Design Kit) with some general type of inductors; but that kind of inductors are usually not the best component for each application For example, an inductor for a low noise amplifier and an inductor for a power amplifier, even if it is required that they both have a given equivalent inductance value, the inductors provided by the PDK do not show good performance in both amplifier circuits. Some additional design task is required in the circuit design in order to obtain optimized performance inductors. But inductor design is carried out using electromagnetic simulation, which is time consuming besides from having a high cost.

That is, the requirement of good performance inductors can increase extremely the computational time, especially when electromagnetic simulators have to be used, making the library characterization process unapproachable.

Summary of the invention

The invention refers to a method for generating an inductor library according to claim 1. Preferred embodiments of the method are defined in the dependent claims

The present invention discloses a method for systematizing the generation of inductors, not only with high Q factor but also with low area consumption requirements, in order to obtain the corresponding optimized inductor library, thereby reducing time consumption from the designer's point of view.

It is thus an objective of the present invention to generate a geometrically compact inductor series, which is further optimized to obtain an optimized inductor series, in order to generate an optimized inductor library on any silicon-based technology.

A first aspect the invention refers to a method for generating an inductor library formed by a series of optimized inductors, which comprises:

- iterating a method for generating an optimized inductor, which inductor is characterised by a set of inductor parameters $\{L_{eq}', N, s_{min}, w_1, w_2, ..., w_N, d(L_{eq})\}$, and
- compiling and storing said inductor parameters according to a pre-established library format.

According to the invention said optimized inductor is a spiral of $N$ turns occupying a square area of $DxD$, $D$ being its outer dimension, and where s is the turn-to-turn spacing, $d$ its inner dimension, $w_i$ is the width of the $i$-th turn, with $i$=1, 2, $N$; the inductor having an equivalent inductance $L_{eq}$.

And the method for generating an optimized inductor comprises:

- establishing a maximum size boundary for the outer dimension $D$,
- obtaining a minimum size boundary for the outer dimension $D$, and
- within the area defined between the minimum and the maximum size boundaries apply the following optimization process:

- for a given inductance value $L_{eq}$ fix a starting set of parameters $\{N, s_{min}, w_{min}, d_{min}.\}$ of the inductor by said minimum size boundary,
- modify the constant turn-width $w_{min}$ to obtain the optimized turn-width $w_{opt}$ which enhances the Q factor of the inductor;
- modify the inner dimension $d_{min}$ to adjust the inductance value $d(L_{eq})$;
- modify the turn-width in each turn to take into account the magnetic flux, making the (i+1)-th turn wider than the i-th turn and obtaining a set of optimized turn-widths $\{w_1, w_2, ..., w_N\}$;
- calculate the new equivalent inductance value $L_{eq}'$,

whereby the optimized inductor is defined by the following parameters $\{L_{eq}', N, s_{min}, w_1, w_2, ..., w_N, d(L_{eq})\}$.

Thus, with the above method, an optimized inductor series is generated to obtain an integrated inductor library, which fulfils the best inductor requirements (within the technology constraints).

According to a preferred embodiment, the step of obtaining a minimum size boundary comprises:

- defining the outer dimension $D$ of the inductor as a function which is only dependent on geometrical parameters of the inductor:

$$D = f(N, s, w, d);$$

- fixing the turn-to-turn spacing s and the constant strip-width w to a minimum permitted by design rules, whereby the outer dimension is a function dependent on the inner dimension $d$ and the number of turns $N$:

$$D_{min} = f(N, s_{min}, w_{min}, d) \equiv D(N, d);$$

- defining a set of target equivalent inductance values $\{L_{eq}^1, L_{eq}^2, ..., L_{eq}^i\}$;
- for each target equivalent inductance value $L_{eq}^i$, preparing inductor layouts with a predefined quantity $k^i$ of discrete values $N_k^i$ of the number of turns $N$;
- carrying out simulations for each of said $\sum_i k^i$ prepared inductor layouts varying the inner dimension d during each simulation, in order to derive an inductor with the target equivalent inductance value $L_{eq}^i$;
- obtaining a set of minimum inductors $\{Ind^1, Ind^2, ..., Ind^i\}$, by identifying in said simulated inductor layouts, for each target equivalent inductance value $L_{eq}^i$, the inductor layout with the smallest outer dimension $D$;
- obtaining a minimum size boundary by fitting a curve to said set of minimum inductors $\{Ind^1, Ind^2, Ind^3, ...\}$ using a non-linear expression.

Design rules are a series of parameters (such as minimum line space, width, hole, etc.) provided by semiconductor manufacturers that enable the designer to verify the correctness of the physical layout design. Design rules are specific to a particular semiconductor manufacturing process. That is, the invention proposes a method for designing a compact size inductor that takes into account the geometrical parameters of the inductor, such as number of turns, line width, line spacing, inner diameter, etc optimizing the area used by the inductor.

The optimization process preferably includes a further iteration on the inner dimension $d_{min}$ parameter to more accurate results on the equivalent inductance value $L_{eq}$.

Said minimum size boundary may be defined by the following non-linear expression:

$$D_{min} = a \times \left(L_{eq}\right)^b$$

where a and b are parameters obtained by fitting the obtained set of minimum inductors $\{Ind^1, Ind^2, Ind^3, ...\}$.

The equation which defines the outer dimension D as a function only dependent on geometrical parameters of the inductor may be as follows:

$$D = d + 2w + 2(N\text{-}1) * (w + s),$$

where $d$, $S$ and $w$ are a fixed to a constant value, which is the minimum allowed value according to design rules.

The set of target equivalent inductance values $\{L_{eq}^1, L_{eq}^2, ..., L_{eq}^i\}$ can be defined or chosen at the designer's will or needs. Generally, the set can be defined according to the circuit specification of frequency range. For example, at an operating frequency of 2.4 GHz, it is sufficient with inductance values between 1 and 10 nH. At a lower frequency, for example some hundreds of MHz, it will be required to chose inductance values around 20 or 30 nH,

During each simulation the value of the number of turns is fixed to a value; and there is a predefined quantity $k^i$ or number of discrete values of the number of turns $N$, which quantity can be different for each target inductance value $L_{eq}^i$ And this predefined quantity $k^i$ of discrete values $N_k^i$ of the number of turns $N$ for each target equivalent inductance value $L_{eq}^i$ can be predefined from a rough estimation of a mathematical calculation, since the equivalent inductance value $L_{eq}^i$ is proportional to the length of the inductor. For certain $L_{eq}$ target values with two different values for $N$ is enough, and in some other cases three different $N$ may be needed. In general terms, simulating for three different values of $N$ is enough.

That is, the invention proposes a method for generating an inductor library, by systematizing the generation of optimized inductors, taking into account the geometrical parameters and the Q factor of the inductor The inductor library generated by the method of the present invention satisfies designers' requirements, such as high Q factor, small area occupation, etc, for a given inductance value at a fixed working frequency.

The present invention can be applied systematically in order to generate a complete inductor library covering the most appreciated requirements for any technology, such as silicon, Gallium-Arsenide, ceramics, etc

Brief description of the drawings

To complete the description and in order to provide for a better understanding of the invention, a set of drawings is provided. Said drawings form an integral part of the description and illustrate preferred embodiments of the invention, which should not be interpreted as restricting the scope of the invention, but just as examples of how the invention can be embodied. The drawings comprise the following figures:

Figure 1 shows a block diagram showing the main steps of the method for generating an inductor library.
Figure 2 shows the geometry of an on-chip integrated inductor, having a square spiral shape.
Figure 3 shows a set of simulations of the minimum outer dimension $D_{min}$ behaviour for every inductance value $L_{eq}$ in the frequency range of interest.
Figure 4 shows the fitting curve which represents the minimum outer dimension $D_{min}$ required to implement an inductor with a desired $L_{eq}$.
Figure 5 shows a flowchart of the optimizing process of the invention for a given fixed inductance value.

Detailed description of the preferred embodiments

Reference will now be made in detail to a preferred embodiment of the method of the present invention, which aims at generating an inductor library.

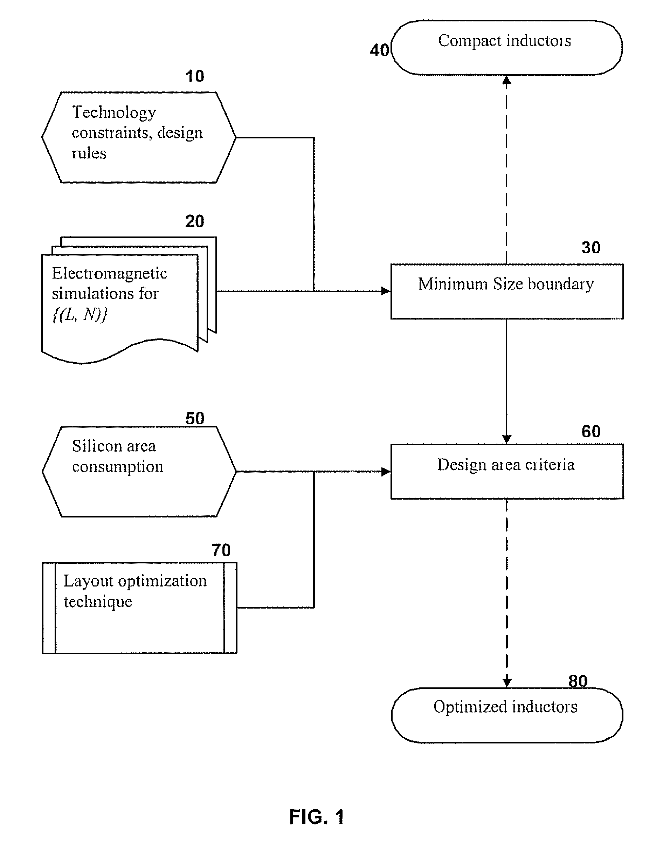

Figure 1 is a block diagram showing the main steps of the procedure of generating an inductor library. On the left-hand side of this block diagram are the inputs to the method, while the procedure is synthesized on the right-hand side.

The first step 10 consists in the study of the technological possibilities to reach the allowed inductor parameters for the most geometrically compact structures, which should also present the best performance,

Then, a Minimum Size Boundary is defined (step 30) using a method-of-moments based simulator (step 20) and a Compact Inductors Series is generated (step 40). A compact size inductor is defined as an inductor which minimizes area consumption.

The following step 50 is to define a substrate area occupation criterion, from the minimum allowed size defined by the Minimum Size Boundary, up to a maximum size boundary defined by the designer's requirement, taking into account the maximum area consumption allowed. A Design Area Criteria is then established 60: from the minimum to the maximum size boundaries.

This "extra" area available leads to the implementation of a systematic procedure for the optimized layout generation (step 70).

Therefore, an Optimized Inductors Series can be finally generated 80 to obtain an integrated inductor library.

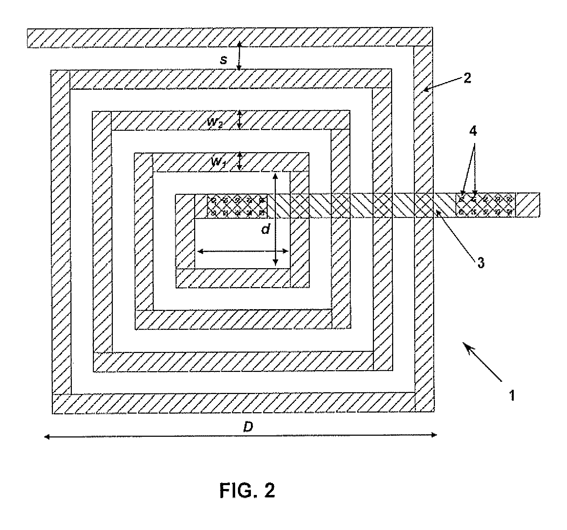

Figure 2 shows the main geometrical parameters of a basic square inductor 1, with two metal levels on a silicon-based technology, top metal 2 and bridge metal 3, with the corresponding vias 4; the top metal usually presents major thickness The main geometrical inductor parameters can be defined as follows: $N$, number of turns; $s$, turn-to-turn spacing; $d$, inner dimension; $D$, outer dimension, $w_i$, width of the ith turn of the spiral (i= 1, ... N).

Other usual inductor geometries (i.e circular or octagonal) are not to be discarded. However, the final occupied inductor area inside the device integration area will always be a squared area, independently of the intrinsic geometry of the structure. The square geometry can fill better the vertices of the final area, presenting lower metal losses and hence better performances; otherwise, other geometries should be considered

In order to obtain a minimum size boundary, "geometrical constraints" are first considered; these constraints depend on the design rules or inductor parameters indicated before: turn-to-turn or line spacing $s$, line width $w$ and inner dimension $d$, which are provided by semiconductor manufacturers and enable the designer to verify the correctness of the physical layout design, A constant strip or line width w inductor is considered.

$s$ and $w$ are a fixed to a constant value, not variable during whole procedure, which is the minimum allowed value according to design rules. The inner dimension $d$ is also a given value by the designer's requirements, for example, how many vias the designer wants to include in order to connect the top metal and bridge metal (Figure 1) The outer dimension of the inductor $D$ can be calculated as follows:

$$D = d + 2w + 2(N-1) * (w + s). \qquad [1]$$

As the turn-to-turn spacing s and the constant line width $w$ have been fixed to a minimum permitted by design rules, the outer dimension is a function only dependent on the number of turns $N$ and of the inner dimension $d$:

$$D_{min} = f(N, s_{min}, w_{min}, d) \equiv D(N, d). \qquad [2]$$

The next step consists in finding the minimum outer dimension $D_{min}$ behaviour for each target inductance value, for example, 1 nH, 2 nH, ..., 9 nH, 10 nH, in the frequency range of interest, taking advantage of an electromagnetic field solver (e. g, a method-of-moments based simulator) These simulations take into account different number of turns $N$ As it will be explained further below, this set of simulations $[L_{eq}, N]$ leads to a "minimum size boundary".

In order to carry out these simulations, a set of target inductance values is defined (step A) Generally, this set of $L_{eq}$ can be defined according to the circuit specification of frequency range, For example, at an operating frequency of 2.4 GHz, it is sufficient with inductance values between 1 and 10 nH. At a lower frequency, for example some hundreds of MHz, it will be required to chose inductance values around 20 or 30 nH.

Then for each target equivalent inductance value $L_{eq}^i$, inductor layouts are prepared (step B) with a predefined quantity $k^i$ of discrete values $N_k^i$ of the number of turns $N$. So during each simulation the value of the number of turns is fixed to a value; and there is a predefined quantity $k^i$ or number of discrete values of the number of turns $N$. This predefined quantity $k^i$ of discrete values $N_k^i$ of the number of turns $N$ for each target equivalent inductance value $L_{eq}^i$ can be predefined from a rough estimation of a mathematical calculation, since the equivalent inductance value $L_{eq}^i$ is proportional to the length of the inductor.

For example: for $L_{eq}^1$=1nH, it is sufficient with $k^1$=2 and the discrete values are $N_1^1$=3 and $N_2^1$=4. Then for $L_{eq}^2$=2nH, $k^2$=3 and the discrete values of the number of turns are $N_1^2$=4, $N_2^2$=5 and $N_3^2$=6; .. ; and for $L_{eq}^{10}$=10nH, $k^{10}$=2 and the discrete values of the number of turns are $N_1^{10}$=9, and $N_2^{10}$=10.

Once the inductor layouts have been prepared, simulations are carried out with an electromagnetic field simulator (by method-of-moments, finite element method, etc.), for the different number of turns (step C). During this simulation the variable parameter is the inner dimension $d$ -which implies a variation also in the total length of the inductor-, in order to obtain or derive the target inductance value $L_{eq}$ for each inductor (this step is also called optimization of $L_{eq}$).

Simulations are carried out for all the inductor layouts prepared in step B

Once the optimization of $L_{eq}$ is finished, $k^i$ optimized inductor layouts are obtained and the resulting outer dimension D among then can be compared (step D) After simulation, it is seen that in order to derive the same $L_{eq}$ with different number of turns $N$, the inductor with the smaller number of turns (N=3 in this case) occupies a larger area (has a larger outer dimension $D$) than the inductor with a bigger $N$ (N=4 in this case) It would have also been possible to prepare the inductor layout for N=5 turns, and then check to see if the resulting optimized inductor is smaller -it obviously depends on design time-, but as indicated before, the designer knows that with 5 turns the corresponding inductor would be too long (with the consequent influence on $L_{eq}$)

Then, for each $L_{eq}^i$ the inductor with the smallest outer dimension $D$ is chosen (step E).

So in this case, for $L_{eq}^1$=1nH, the minimum simulated inductor $Ind^1$ chosen is the one corresponding to 4 turns. And for the case of $L_{eq}^2$=2nH, the chosen inductor $Ind^2$ corresponds to 5 turns,

This way, after the previous step (step E) a set of minimum inductors {Ind[1], Ind[2], ..., Ind[i]} is obtained (step F).

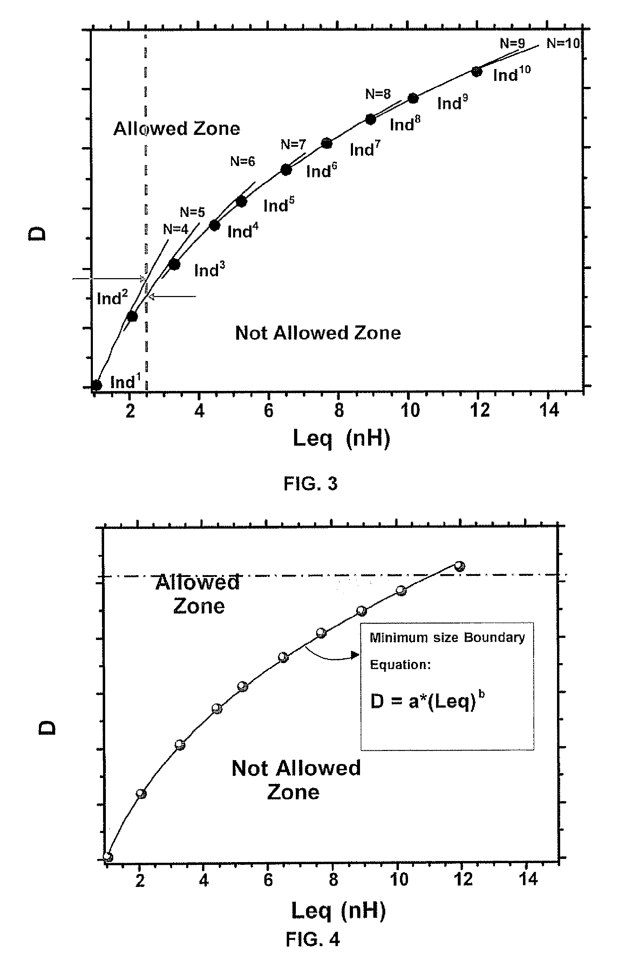

A minimum size boundary (see figure 4) is then obtained by fitting a curve to that set of minimum inductors {Ind[1], Ind[2], Ind[3], ....} using the following non-linear expression:

$$D_{min} = a \times \left(L_{eq}\right)^b \qquad\qquad [3]$$

Possible examples of valid values for *a* and *b* are a=100 and b=0.34, for $D_{min}$=100 um and $L_{eq}$=1 nH at a frequency of 25 GHz.

The continuous lines in figure 3 correspond to the relationship between the outer dimension *D* and the equivalent inductance $L_{eq}$ for different values of the number of turns *N* (*N*=1, 2,.. 10). The dots in figure 3 indicate the location of the inductor test structures (Ind1, Ind2, Ind3, .. Ind10) which have been designed and derived; these data have been obtained using electromagnetic simulation on a semiconductor substrate. In this example every inductance value has been calculated at an operating frequency of 2.5 GHz.

As it has also been explained before, for a given inductance value $L_{eq}$ it is possible to have more than one inductor implementation. An example of this is shown by the dashed line in figure 3, where for a given equivalent inductance value of 25 nH there are two possible inductor implementations: one of them corresponds to *N*=4 and the other to *N*=5 (both are indicated by arrows in this figure 3). The design algorithm is then able to select the implementation corresponding to the smaller outer dimension *D*

There are two zones in the *D* vs. $L_{eq}$ plot shown in figure 3 (also in fig. 4): the "Allowed Zone" and the "Not Allowed Zone". In the "allowed zone", the pairs [*D*, $L_{eq}$] always correspond to realizable inductors. On the contrary, in the "not allowed zone", no inductors can be designed having the desired $L_{eq}$ and *D* values. The boundary (the minimum size boundary) between both zones indicates the minimum *D* required to implement an inductor with the desired $L_{eq}$ due to the design rules

Figure 4 shows this minimum size boundary (the solid-line curve), which is a curve that has been fitted using the non-linear expression [3] or fitting equation indicated above, and also shown on the figure inset.

Similar fitting functions can be found in literature: *"The Design of CMOS Radio Frequency Integrated Circuits, 2nd edition"* Thomas H. Lee, Cambridge Univ. Press, pp. 136-144. The test inductors locations are also shown in this figure 4 as dots

From the designer's point of view, there is a criterion to establish the maximum allowed area (maximum outer dimension) for an inductor. Once this maximum is fixed, a Design Area is established (step 60): from the minimum size defined by the minimum size boundary up to the maximum allowed area; the area between these limits is the extra margin area to apply an optimization process: in principle, the larger the area, the better the improvements that may be achieved on Q factor.

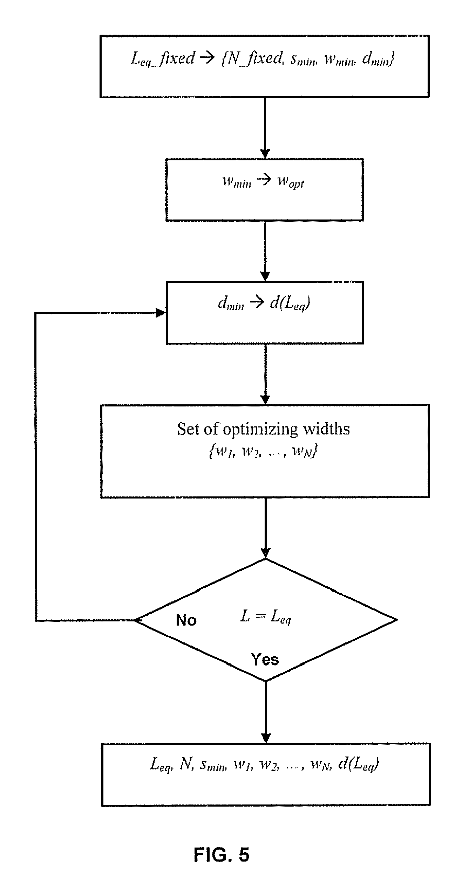

Once the minimum size boundary or fitting curve has been obtained, the optimization process (step 80) to obtain an optimized inductor series (step 80) for a given inductance value $L_{eq}$ is as follows (this optimizing process is shown in the flowchart in figure 5):

- for a given inductance value $L_{eq}$ fix a starting set of parameters {*N*, $S_{min}$, $w_{min}$, $d_{min}$} of the inductor by said minimum size boundary;
- modify the constant turn-width $w_{min}$ to obtain the optimized turn-width $w_{opt}$ which enhances the Q factor of the inductor;
- modify the inner dimension $d_{min}$ to adjust the inductance value $d(L_{eq})$;
- modify the turn-width in each turn to take into account the magnetic flux, making the (i+1)-th turn wider than the i-th turn and obtaining a set of optimized turn-widths {$w_1$, $w_2$, ..., $w_N$};
- calculate the new equivalent inductance value $L_{eq}'$,
  whereby the optimized inductor is defined by the following parameters {$L_{eq}'$, *N*, $s_{min}$, $w_1$, $w_2$, ..., $w_N$, $d(L_{eq})$}.
  In order to obtain more accurate results on the equivalent inductance value $L_{eq}'$, additional iteration on the inner diameter parameter $d_{min}$ is advisable during the process, especially, at the end of the process.

Simulating and designing inductors may be done with any electromagnetic field solver, using "method of moments", "finite element method", etc. in 2.5-dimension, 3-dimension structures.

The method of the invention can be automated by programming.

As indicated before, the present invention relates to a method for designing compact size inductors It is to be understood that the above disclosure is an exemplification of the principles of the invention and does not limit the invention to the illustrated embodiments.

**Claims**

1.  Method for generating an inductor library formed by a series of optimized inductors, which comprises:

    - iterating a method for generating an optimized inductor, which inductor is **characterised by** a set of inductor parameters $\{L_{eq}, N, s_{min}, w_1, w_2, ..., w_N, d(L_{eq})\}$, and
    - compiling and storing said inductor parameters according to a pre-established library format,
    said optimized inductor being a spiral of $N$ turns occupying a square area of $D$x$D$, $D$ being its outer dimension, and where $s$ is the turn-to-turn spacing, $d$ its inner dimension, $w_i$ is the width of the $i$-th turn, with $i$=1, 2, ... $N$; the inductor having an equivalent inductance $L_{eq}$,
    wherein said method for generating an optimized inductor comprises:
    - establishing a maximum size boundary for the outer dimension $D$,
    - obtaining a minimum size boundary for the outer dimension $D$, and
    - within the area defined between the minimum and the maximum size boundaries apply the following optimization process:

        - for a given inductance value $L_{eq}$ fix a starting set of parameters $\{N, s_{min}, w_{min}, d_{min.}\}$ of the inductor by said minimum size boundary,
        - modify the constant turn-width $w_{min}$ to obtain the optimized turn-width $w_{opt}$ which enhances the Q factor of the inductor;
        - modify the inner dimension $d_{min}$ to adjust the inductance value $d(L_{eq})$;
        - modify the turn-width in each turn to take into account the magnetic flux, making the (i+1)-th turn wider than the i-th turn and obtaining a set of optimized turn-widths $\{w_1, w_2, ..., w_N\}$;
        - calculate the new equivalent inductance value $L_{eq}'$,

    whereby the optimized inductor is defined by the following parameters $\{L_{eq}', N, s_{min}, w_1, w_2, ..., w_N, d(L_{eq})\}$.

2.  Method according to claim 1, wherein the step of obtaining a minimum size boundary comprises:

    - defining the outer dimension $D$ of the inductor as a function which is only dependent on geometrical parameters of the inductor:

    $$D = f(N, s, w, d);$$

    - fixing the turn-to-turn spacing s and the constant strip-width $w$ to a minimum permitted by design rules, whereby the outer dimension is a function dependent on the inner dimension d and the number of turns $N$:

    $$D_{min} = f(N, s_{min}, w_{min}, d) \equiv D(N, d);$$

    - defining a set of target equivalent inductance values $\{L_{eq}^1, L_{eq}^2, ..., L_{eq}^i\}$;
    - for each target equivalent inductance value $L_{eq}^i$, preparing inductor layouts with a predefined quantity $k^i$ of discrete values $N_k^i$ of the number of turns $N$;

    - carrying out simulations for each of said $\sum_i k^i$ prepared inductor layouts varying the inner dimension $d$ during each simulation, in order to derive an inductor with the target equivalent inductance value $L_{eq}^i$;
    - obtaining a set of minimum inductors $\{Ind^1, Ind^2, ..., Ind^i\}$, by identifying in said simulated inductor layouts, for each target equivalent inductance value $L_{eq}^i$, the inductor layout with the smallest outer dimension $D$;
    - obtaining a minimum size boundary by fitting a curve to said set of minimum inductors $\{Ind^1, Ind^2, Ind^3, ...\}$ using a non-linear expression.

3.  Method according to claim 2, wherein said minimum size boundary is defined by the non-linear expression:

$$D_{min} = a \times \left(L_{eq}\right)^{b}$$

where *a* and *b* are parameters obtained by fitting the obtained set of minimum inductors {Ind[1], Ind[2], Ind[3], ...}.

4. Method according to any of claims 2-3, wherein the predefined quantity $k^i$ of discrete values $N_k^i$ of the number of turns *N* for each target equivalent inductance value $L_{eq}^i$ is defined as a prior estimation since the equivalent inductance value $L_{eq}^i$ is proportional to the length of the inductor.

5. Method according to any of claims 2-4, wherein the set of target equivalent inductance values {$L_{eq}^1$, $L_{eq}^2$, .., $L_{eq}^i$} is defined according to the specification of frequency range

6. Method according to any previous claim, wherein the optimization process includes a further iteration on the inner dimension $d_{min}$ parameter to more accurate results on the equivalent inductance value $L_{eq}$.

**40** Compact inductors

**10** Technology constraints, design rules

**20** Electromagnetic simulations for *{(L, N)}*

**30** Minimum Size boundary

**50** Silicon area consumption

**60** Design area criteria

**70** Layout optimization technique

**80** Optimized inductors

**FIG. 1**

FIG. 2

**FIG. 3**

Minimum size Boundary
Equation:

$$D = a*(Leq)^b$$

**FIG. 4**

$L_{eq}\_fixed \rightarrow \{N\_fixed,\ s_{min},\ w_{min},\ d_{min}\}$

$w_{min} \rightarrow w_{opt}$

$d_{min} \rightarrow d(L_{eq})$

Set of optimizing widths
$\{w_1,\ w_2,\ ...,\ w_N\}$

**No**     $L = L_{eq}$

**Yes**

$L_{eq},\ N,\ s_{min},\ w_1,\ w_2,\ ...,\ w_N,\ d(L_{eq})$

FIG. 5

# EP 2 015 204 A1

## European Patent Office

# EUROPEAN SEARCH REPORT

**Application Number**

EP 07 11 1896

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 6 311 145 B1 (HERSHENSON MARIA DEL MAR [US] ET AL) 30 October 2001 (2001-10-30)<br>* abstract *<br>* column 1, line 57 - column 2, line 3; figure 2 *<br>* column 2, line 62 - column 3, line 19 *<br>* column 4, line 51 - column 5, line 8 *<br>* column 8, line 11 - column 9, line 62 *<br>----- | 1-6 | INV.<br>G06F17/50 |
| Y | US 2003/210121 A1 (BENG SIA CHOON [SG] ET AL) 13 November 2003 (2003-11-13)<br>* abstract *<br>* figures 1a,4a,6,7 *<br>* paragraph [0001] *<br>* paragraphs [0015] - [0019] *<br>* paragraph [0042] *<br>----- | 1-6 | |
| A | US 6 588 002 B1 (LAMPAERT KOEN [US] ET AL) 1 July 2003 (2003-07-01)<br>* abstract *<br>* column 1, lines 7-12 *<br>* column 3, lines 6-33 *<br>----- | 1-6 | |
| A | ALI M NIKNEJAD ET AL: "Analysis, Design, and Optimization of Spiral Inductors and Transformers for Si RF IC's"<br>IEEE JOURNAL OF SOLID-STATE CIRCUITS, IEEE SERVICE CENTER, PISCATAWAY, NJ, US,<br>vol. 33, no. 10, October 1998 (1998-10), XP011060832<br>ISSN: 0018-9200<br>* the whole document *<br>-----<br>-/-- | 1-6 | TECHNICAL FIELDS SEARCHED (IPC)<br>G06F<br>H01F<br>H01L |

The present search report has been drawn up for all claims

| Place of search | Date of completion of the search | Examiner |
|---|---|---|
| Munich | 15 November 2007 | Anticoli, Claud |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 07 11 1896

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DEL MAR HERSHENSON M ET AL: "Optimization of Inductor Circuits via Geometric Programming" DESIGN AUTOMATION, 1999. 36TH ANNUAL CONFERENCE ON NEW ORLEANS, LA, USA 21-25 JUNE 1999, PISCATAWAY, NJ, USA,IEEE, 21 June 1999 (1999-06-21), pages 994-998, XP010762163 ISBN: 1-58113-109-7 * the whole document * ----- | 1-6 | |
| Y | US 2004/140878 A1 (HEIMA TETSUYA [JP]) 22 July 2004 (2004-07-22) * paragraph [0033] * ----- | 1-6 | |

TECHNICAL FIELDS SEARCHED (IPC)

The present search report has been drawn up for all claims

| Place of search | Date of completion of the search | Examiner |
|---|---|---|
| Munich | 15 November 2007 | Anticoli, Claud |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

.................................................................................

& : member of the same patent family, corresponding
      document

EPO FORM 1503 03.82 (P04C01)

## ANNEX TO THE EUROPEAN SEARCH REPORT
## ON EUROPEAN PATENT APPLICATION NO.

EP 07 11 1896

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2007

| Patent document cited in search report | | Publication date | Patent family member(s) | | Publication date |
|---|---|---|---|---|---|
| US 6311145 | B1 | 30-10-2001 | AU<br>WO | 5492200 A<br>0079440 A1 | 09-01-2001<br>28-12-2000 |
| US 2003210121 | A1 | 13-11-2003 | NONE | | |
| US 6588002 | B1 | 01-07-2003 | NONE | | |
| US 2004140878 | A1 | 22-07-2004 | DE<br>JP<br>TW | 10340391 A1<br>2004221475 A<br>224855 B | 05-08-2004<br>05-08-2004<br>01-12-2004 |

EPO FORM P0459

For more details about this annex : see Official Journal of the European Patent Office, No. 12/82

**REFERENCES CITED IN THE DESCRIPTION**

**Non-patent literature cited in the description**

- **THOMAS H. LEE.** The Design of CMOS Radio Frequency Integrated Circuits. Cambridge Univ. Press, 136-144